# EUROPEAN PATENT APPLICATION

(11) **EP 2 244 379 A1**
(43) Date of publication of application: **27.10.2010**
(21) Application number: 09305346.0
(22) Date of filing: 23.04.2009
(51) Int. Cl.: H03F 1/30, H03F 1/34, H03F 3/189

(54) **Method for preventing impacts by a power detector on a signal path of an RF circuit, device, power amplifier system, and network element thereof**

(71) Applicant: Alcatel Lucent, 75008 Paris (FR)
(72) Inventor: Klauke, Gerd, 30179 Hannover (DE)
(74) Representative: Brose, Gerhard

(57) **Abstract**

The invention relates to a method for preventing impacts of a power detector (PD) on a signal path (SP) of on RF circuit (RFC). The method comprises the steps of coupling a fraction (FRAC) of a first RF signal (RF_S1) from the signal path (SP) to a feedback path (FP1), wherein the method further comprises the steps of amplifying the fraction (FRAC) of the first RF signal (RF_S1) to a second RF signal (RF_S3) via a first power amplifies (PA1) of the feedback path (FP1), detecting the amplified second RF signal (RF_52) at the power detector (PD) of the feedback path (FP1), and attenuating disturbing signals at the first power amplifier (PA1) in a backward direction (BD) of the first power amplifier (PA1).

## Description

### FIELD OF THE INVENTION

The invention relates to a method for preventing impacts of a power detector on a signal path of an RF circuit according to the preamble of claim 1 and to a device according to the preamble of claim 13.

### BACKGROUND OF THE INVENTION

Radio communication systems are required to operate under a wide range of environmental conditions. One of these conditions is for example a large temperature range such as from -20 °C to +60 °C, in which any performance degradation of equipment of the radio communication systems should be avoided or limited to an acceptable level. Power amplifiers in a receiving path of an RF front end (RF = radio frequency) of a network element such as a base station or a mobile station require a large linear dynamic gain and a high sensitivity for detecting a large range of power levels of a received input signal. These characteristics should be unchanging within the large temperature range.

A power amplifier is designed to provide a linear gain up to a predefined power level of the received input signal. For power levels above the predefined power level, a saturation of the gain of the power amplifier is observed, which increases a signal-to-noise-ratio of an output signal of the power amplifier.

The power level of the received input signal usually varies and depends on an output power of a transmitter, on a distance between the transmitter and a receiver comprising the power amplifier, and on attenuation during propagation from the transmitter to the receiver.

Fading for example requires a continuous adjustment in the receiver's gain in order to maintain a power level of an output signal of the receiver in a predefined range.

Therefore and for avoiding a risk of gain saturation in case of high input power levels, AGC circuits (AGC = automatic gain control) are used, which feeds back a portion of the output signal of the power amplifier to adjust a VCA (VCA = voltage controlled amplifier) or a VGA (VGA = variable gain amplifier) in front of the power amplifier.

Usually for low received input signals, the AGC is disabled and the output signal is a linear function of the received input signal. When the output signal reaches an activation threshold of the AGC, the AGC becomes operative and maintains the power level of the output signal of the receiver in the predefined range.

Components such as the VCA in combination with the power amplifier or the VGA in combination with the power amplifier within a signal path of the receiver cause an operating gain of the receiver to fluctuate due to changes such as in ambient temperature or in frequency. The AGC circuit typically compensates for these influences on the components of the signal path. But even with AGC, a reliable mass production of receivers having a desired operating gain due to fabrication tolerances is difficult. Furthermore, there is no compensation effect for these influences on components of a feedback path of the AGC circuit.

In US 6,677,823 B2 an automatic gain compensation circuit for actively adjusting the gain of an amplifier caused by in-loop and/or out-of-loop influences on system gain is disclosed. Two matched RF detectors convert pre- and post-amplified signals to input and output voltages representative of the power of the RF signals. During amplifier operation, an offset voltage is adjusted by a processing unit to compensate for gain changes in the amplifier due to oul-of-loop temperature-related influences on system gain. If the output signal of the power amplifier is coupled to the feedback path of the AGC circuit and is detected by a power detector of the feedback path using rectification, secondary effects such as generation of intermodulation signals degrade the signal quality of the output signal of the power amplifier in the signal path. If the output signal comprises at least two carrier signals with a spacing of 1 MHz for example, diodes of the power detector generate additional signal components next to the at least two carrier signals with the spacing of 1 MHz by non-linear effects. The additional signal components travel in a backward direction, are coupled to the signal path and are superimposed to the output signal of the power amplifier.

The way of generating a feedback signal using the power detector in the feedback path affects the signal quality of the output signal of the power amplifier.

Therefore, it is the object of the invention to improve the signal quality of the output signal of the power amplifier.

### SUMMARY OF THE INVENTION

This object is achieved by a method for preventing impacts of a power detector on a signal path of an RF circuit. The method comprises the steps of coupling a fraction of a first RF signal from the signal path to a feedback path, wherein the method further comprises the steps of amplifying the fraction of the first RF signal to a second RF signal via a first power amplifier of the feedback path, detecting the amplified second RF signals at the power detector of the feedback path, and attenuating disturbing signals at the first power amplifier in a backward direction of the first power amplifier.

The object is further achieved by an independent claim 13 for a device.

The method according to the present invention offers a benefit of increasing the signal quality of the output signal of the signal path of the RF circuit. An isolating characteristic of the first power amplifier in the backward direction is used to suppress disturbing signals such as intermodulation signals travelling back to the signal path.

In a first embodiment of the invention, the fraction of the first RF signal is below a first predefined threshold.

This provides the benefit of coupling only a small fraction of the first RF signal to the feedback path and using most of the first RF signal for the output signal of the signal path of the RF circuit.

Because a power level of the fraction of the first RF signal is well below an operating point of the power detector with a large sensitivity, a further advantage is the possibility to use the first power amplifier in the feedback path for amplifying the fraction of the first RF signal.

In a second embodiment of the invention, a power level of the second RF signal is adapted to an operating point of the power detector with a sensitivity above a second predefined threshold.

This provides the advantage of increasing the sensitivity of the feedback path for detecting small changes in the signal path SP, it only the fraction of the first RF signal is coupled to the feedback path.

In a first application of the first embodiment, the operating point of the power detector is adjusted by the fraction of the first RF signal being within a first predefined range.

Thereby, a coupling factor of a coupler for coupling the fraction of the first RF signal can be adapted to adjust the operating point of the power detector for the sensitivity above the second predefined threshold. The coupling factor of the coupler may be changed by exchanging components such as a resistor of the coupler.

In a second application of the first embodiment, the operating point of the power detector is adjusted by an operating gain of the first power amplifier being within a second predefined range.

The second application provides the advantage of being more flexible in adjusting the operating point of the power detector by tuning for example a voltage of the first power amplifier and not needing to assemble adequate components like for the first application.

In a third application of the first embodiment, the operating point of the power detector is adjusted roughly by the fraction of the first RF signa being within the first predefined range and is adjusted finely by the operating gain of the first power amplifier being within the second predefined range.

The third application provides for even more flexibility in adjusting the operating point of the power detector.

In a third embodiment of the invention, the method further comprises the steps of generating an output signal at the power detector for the received second RF signal, generating a reference signal by a voltage divider circuit, generating a difference signal for the reference signal and for the output signal of the power detector, amplifying the difference signal to a control signal with a temperature behaviour within a sixth predefined range, and applying the control signal to the signal path.

The third embodiment of the invention provides the further advantage of compensating a temperature characteristic of active components of the feedback path and maybe also the signal path and generating an overall temperature response of all components of the signal path and the feedback path, which is independent of the ambient temperature. If the RF circuit comprises for example a second power amplifier, the characteristics of the second power amplifier such as large dynamic range and high sensitivity can be used over a large temperature range without performance degradation.

In a first application of the third embodiment, the temperature behaviour is adjusted by at least one diode of the voltage divider circuit. In a second application of the third embodiment, the temperature behaviour is adjusted by at least one transistor of the voltage divider circuit. In a third application of the third embodiment, the temperature behaviour is adjusted by a combination of at least one diode and at least one transistor of the voltage divider circuit.

The first, second, and third application provides the benefit of trimming or calibrating a temperature compensation property of the voltage divider circuit by choosing appropriate analogue components such as diodes and/or transistors.

In a fourth application of the third embodiment, an operating point of the voltage divider circuit is adjusted by at least one resistor of the voltage divider circuit.

The fourth application can be used to adjust a voltage level of the reference signed to compensate for fabrication tolerances. This allows for lower requirements on the fabrication process of the components of the signal path and the feedback path. Depended on the performance requirements of the RF circuit, a same resistance value of the at least one resistor may be used for several identical devices comprising the RF circuit.

In a fourth embodiment of the invention, the method further comprises the steps of generating a reference signal, measuring an ambient temperature, generating an output signed at a processing unit for the second RF signal, for the ambient temperature and for calibration data of the processing unit, generating a difference signal for the reference signal and for the output signal of the processing unit, amplifying the difference signal to a control signal with a temperature behaviour within an eighth predefined range, and applying the control signal to the signal path and wherein the temperature behaviour is adjusted by the calibration data.

This provides the advantage of using identical components for the feedback path, because the temperature compensation effect is provided by the calibration data and the reference signal is not needed to be temperature dependent. Fabrication tolerances can be adapted by individual calibration data, which can be derived in a calibration process after the fabrication and prior to the delivery of a device comprising the RF circuit. Depended on the performance requirements of the RF circuit, same calibration data may be used for more than one device comprising the RF circuit.

In an application of the fourth embodiment of the invention, the reference signal is generated by grounding. This provides the benefit of not requiting a voltage supply for generating the reference signal. In that case, a voltage offset required for generating an adequate difference signal may be incorporated into the calibration data.

In a fifth embodiment of the invention, the method further comprises the step of measuring a frequency of an RF signal, and wherein the amplifying of the difference signal to the control signal is done with a frequency behaviour within a ninth predefined range, and wherein the frequency behaviour is adjusted by the calibration data.

This provides the advantage of improving the frequency bandwidth of the feedback path comprising the RF circuit. For incorporating a frequency relation into the calibration data, a frequency response of the components of the signal path and the feedback path may be measured after fabrication and prior to delivery of the device comprising the RF circuit and the frequency response may be used to further adapt the calibration data for an overall frequency behaviour of the components of the signal path and the feedback path, which is independent regarding the frequency.

In a further embodiment of the invention, the feedback path comprising the first power amplifier and the power detector is used for power monitoring the output signal of the RF circuit.

This provides the advantage of observing any degradation of components of the RF circuit or to measure a power efficiency of the RF circuit. Further advantageous features of the invention are defined by dependent claims for the method and for the device and by an independent claim for the device.

### BRIEF DESCRIPTION OF THE DRAWINGS

The embodiments of the invention will become apparent in the following detailed description and will be illustrated by accompanying drawings given by way of non-limiting illustrations.
Figure 1 shows a block diagram of a device comprising an RF circuit in accordance to a first, a second, and a third embodiment of the invention.
Figure 2 shows a flow diagram of a method in accordance to the first, the second, and the third embodiment of the invention.
Figure 3 shows a block diagram of a voltage divider circuit in accordance to a third application of the third embodiment of the invention.
Figure 4 shows a characteristic diagram in accordance to a fourth application of the third embodiment of the invention.
Figure 5 shows a block diagram of a device comprising an RF circuit in accordance to a first application of a fourth and a fifth embodiment of the invention.
Figure 6 shows a block diagram of a device comprising an RF circuit in accordance to a second application of the fourth and the fifth embodiment of the invention.
Figure 7 shows a flow diagram of a method in accordance to the fourth embodiment of the invention.
Figure 8 shows a flow diagram of a further method in accordance to the fifth embodiment of the invention.
Figure 9 shows a block diagram of a power amplifier system in accordance to the embodiments of the invention.
Figure 10 shows a block diagram of a network element in accordance to the embodiments of the invention.

### DETAILED DESCRIPTION OF THE INVENTION

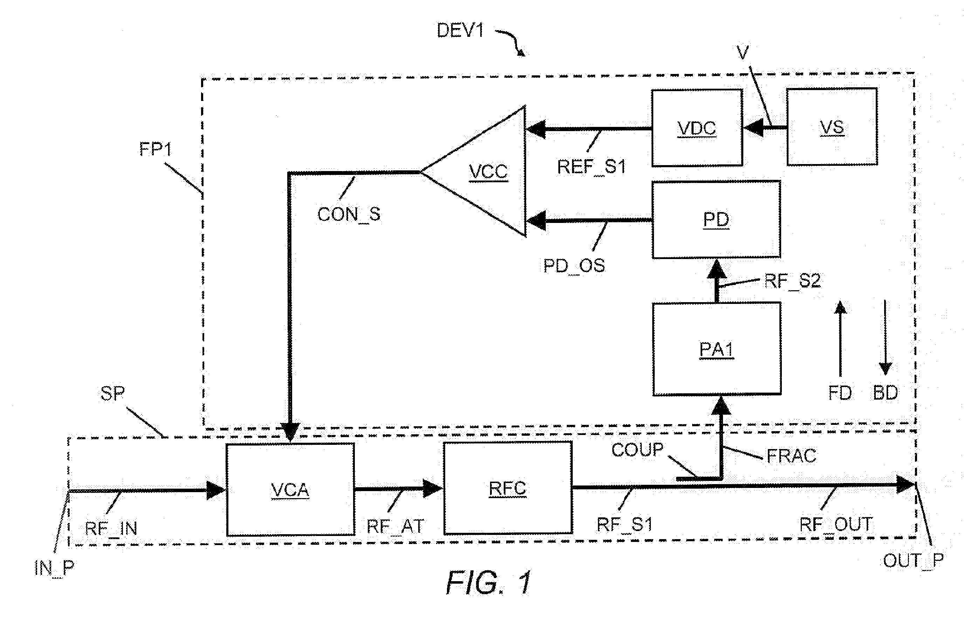

Figure 1 shows a block diagram of a device DEV1 according to a first, a second, and a third embodiment of the invention.

The device DEV1 may be contained in a receiver or transceiver of a network element of a radio communication system such as an LTE system (LTE = Long Term Evolution), a WiMAX system (WiMAX = Worldwide Interoperability for Microwave Access) or a WLAN system (WLAN = Wireless Local Area Network).

The network element is for example a base station such as a BTS (BTS base transceiver station) in GSM/GPRS or a Node Bin UMTS (UMTS = Universal Mobile Telecomimunication System). Alternatively, the network element may be a RRH (RRH = radio remote head), a repeated, an access point, a mobile phone, a PDA (PDA = personal digital assistant), a notebook etc.

In an alternative, the device DEV1 may be contained in a unidirectional or a bidirectiohal power amplifier system. The power amplifier system may be contained in a transceiver of a fixed access communication system such as ADSL (ADSL = Asymmetric Digital Subscriber Line). Generally, the power amplifier system may be used in any application, where an amplification of an electromagnetic signal is required.

In a further alternative, the device DEV1 may be an integral part of an AM radio receiver (AM = amplitude modulation).

The device DEV1 comprises a signal path SP and a feedback path FP1.

The signal path SP comprises an input port IN_P, a voltage controlled attenuator VCA, an RF circuit RFC, a coupler COUP, and an output port OUT_P.

Alternatively, a VGA (VGA = variable gain amplifier) may be used instead of the voltage controlled attenuator VCA.

The RF circuit RFC may comprise a second power amplifier or a frequency mixer.

The signal path SP may comprise further components.

An RF input signal RF_IN coming from the input port IN_P is applied to the voltage controlled attenuator VCA. An attenuated RF signal RF_AT being extracted from the voltage controlled attenuator VCA is applied to the RF circuit RFC. A first RF signal RF_S1 being extracted from the RF circuit RFC is applied to the coupler COUP. The coupler COUP splits the first RF signal RF_S1 into an RF output signal RF_OUT and a fraction FRAC of the first RF signal RF_S1.

According to the first embodiment of the invention, the fraction FRAC of the first RF signal is below a first predefined threshold.

The fraction FRAC of the first RF signal RF_S1 is applied to the feedback path FP1. The RF output signal RF_OUT is applied to the output port OUT_P.

In an alternative, instead of the coupler COUP any other component may be used, which is capable to split the first RF signa! RF_S1 into the RF output signal RF_OUT and the fraction FRAC of the first RF signal RF_S1.

The feedback path FP1 comprises a first power amplifier PA1, a power detector PD, a voltage supply VS, a voyage divider circuit VDC, and a voltage control circuit VCC.

The feedback path FP1 may comprise further components.

The fraction FRAC of the first RF signal FRAC is applied to the first power amplifier PA1. A second RF signal RF_S2 being amplified in a forward direction FD by the first power amplifier PA1 is extracted from the first power amplifier PA1 and applied to the power detector PD.

According to the second embodiment of the invention, a power level of the second RF signal RF_S2 is adapted to an operating point of the power detector PD with a sensitivity above a second predefined threshold.

In a first application of the first embodiment, the operating point of the power detector PD is adjusted by the fraction FRAC of the first RF signal RF_S1 being within a first predefined range.

In a second application of the first embodiment, the operating point of the power detector PD is adjusted by an operating gain of the first power amplifier PA1 being within a second predefined range.

In a third application of the: first embodiment, the operating point of the power detector PD is adjusted roughly by the fraction FRAC of the first RF signal RF_S1 being within a third predefined range and is adjusted finely by the operating gain of the first power amplifier PA1 being within a fourth predefined range.

The power detector PD works as a rectifier and may comprise solid state diodes or vacuum tube diodes.

During a power detection process at the power detector PD parasitic or disturbing signals such as intermodulation signals are generated, which travel in a backward direction BD to the first power amplifier PA1.

An isolating characteristic of the first power amplifier PA1 in the backward direction BD is used to suppress or attenuate the parasitic or disturbing signals.

An Output signal PD_OS of the power detector PD is applied to a first input of the voltage control circuit VCC.

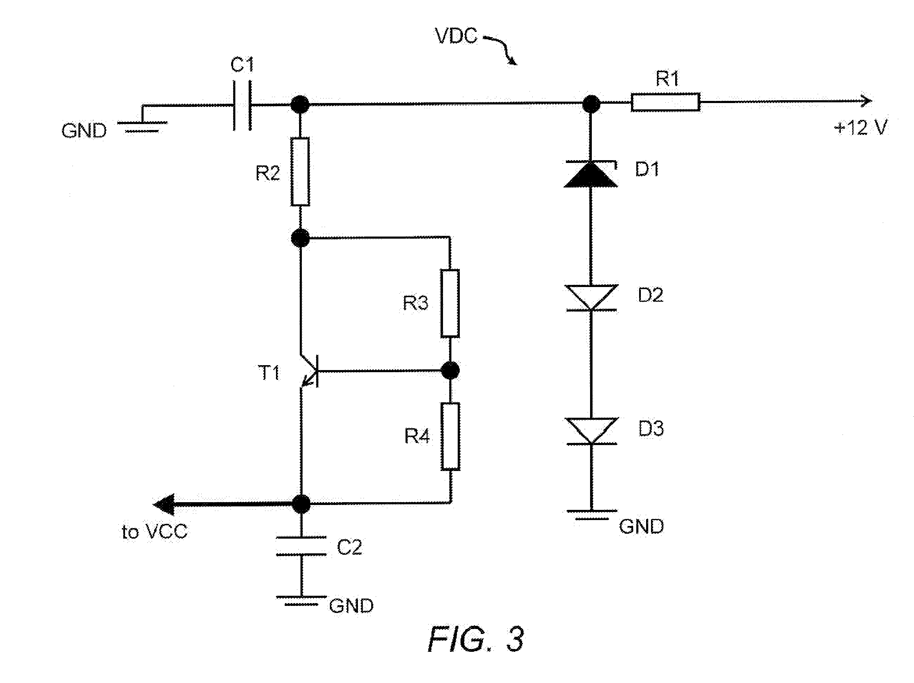

The voltage supply VS applies a voltage V to the voltage divider circuit VDC. The voltage divider circuit VDC comprises analogue electronic components and may comprise an internal structure of resistors and diodes as given for example in Figure 3.

A portion of the voltage V is applied as a reference signal REF_S1 to a second input of the voltage control circuit VCC.

the voltage control circuit VCC may be for example an operational amplifier or a circuit of more than one operational amplifier. A control signal CON_S being extracted from the voltage control circuit VCC is applied to the voltage controlled attenuator VCA of the signal path SP.

The voltage controlled attenuator VCA is operated in such a way, that the attenuated RF signal RF_AT is limited to a fifth predefined range if the RF input signal RF_IN exceeds a third predefined threshold.

If the RF circuit comprises the second power amplifier, the fifth predefined range may be adapted to the upper level of an input power range, for which the second power amplifier provides a linear gain.

Output signals RF_AT, RF_ST of the voltage controlled attenuator VCA and the RF circuit RFC are depending on temperature. The temperature is determined by an ambient temperature and by internal heating effects. Similarly, output signals RF_S2, PD_OS, REF_S1, CON_S of the first power amplifier PA1, the power detector PD, and the voltage control circuit VCC are depending on the temperature.

According to a third embodiment of the invention, the reference signal REF_S1 of the voltage divider circuit VDC depends on the temperature in such a way, that it compensates for output signal deviations of the components PA1, PD, VCC of the feedback path FP1 and maybe also for the components VCA, RFC of the signal path SP. Therewith a temperature behaviour of the control signal CON_S is within a sixth predefined range.

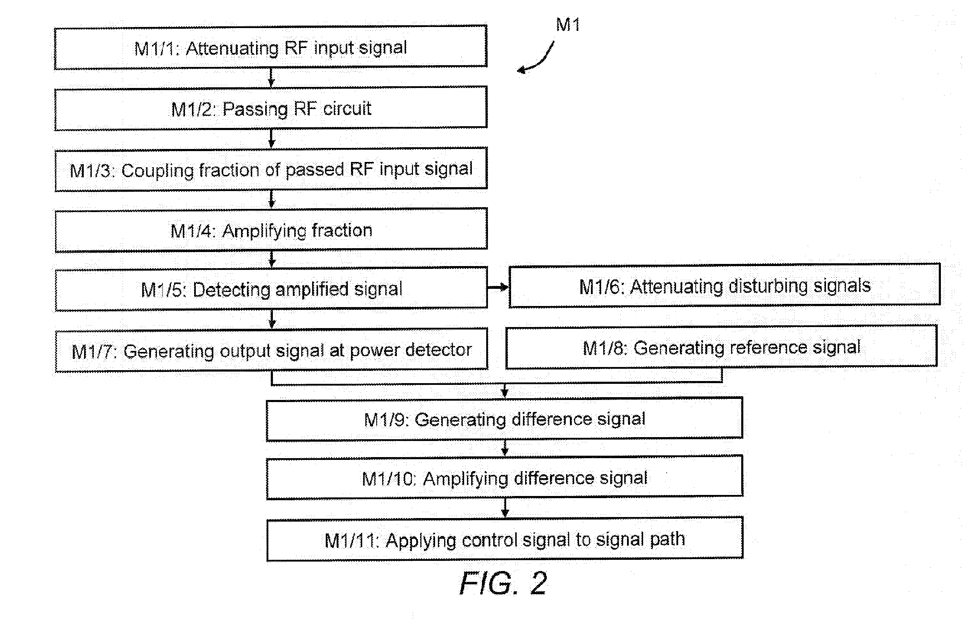

Referring to Figure 2 a flow diagram of a first method M1 in accordance to the first, the second, and the third embodiment of the invention is shown. The sequence and the number of the steps for performing the first method M1 is not critical, and as can be understood by those skilled in the art, that the sequence and the number of the steps may vary without departing from the scope of the invention.

In a first step M1/1, the RF input signal is attenuated by the voltage controlled attenuator VCA. An attenuation degree depends on a voltage level of the control signal CON_S, which is applied to the voltage controlled attenuator VCA.

In a next step M1/2, the attenuated RF signal RF_AT passes the RF circuit RFC. If the RF circuit RFC may comprise a power amplifier, the attenuated RF signal RF_AT is amplified by the RF circuit RFC. If the RF circuit RFC may comprise a frequency mixer, a frequency of the attenuated RF signal RF_AT is upconverted by summing frequencies or downconverted by subtracting frequencies.

In a further step M1/3, the fraction FRAC of the first RF signal RF_S1 is coupled to the feedback path FP1.

The fraction FRAC of the first RF signal RF_S1 may be below the first predefined threshold.

The operating point of the power detector PD may be adjusted by the fraction FRAC of the first RF signal RF_S1 being within the first predefined range.

In a next step M1/4, the fraction FRAC of the first RF signal RF_S1 is amplified by the first power amplifier PA1 to the second RF signal RF_S2. The operating point of the power detector PD may be adjusted by the operating gain of the first power amplifier PA1 being within the second predefined range.

In a further step M1/5, the second RF signal RF_S2 is detected by the power detector PD.

In a next step M1/6, the first power amplifier PA1 attenuates the disturbing signals in the backward direction BD of the first power amplifier PA1, which have been generated during the power detection process at the power detector PD.

In a further step M1/7, the output signal PD_OS of the power detector PD for the received second RF signal RF_S2 is generated.

In a next step M1/8, the reference signal REF_S1 is generated by the voltage divider circuit VDC.

In a further step M1/9, a difference signal is generated by the voltage control circuit VCC for the reference signal REF_S1 and for the output signal PD_OS of the power detector PD.

In a next step M1/10, the difference signal is amplified by the voltage control circuit VCC to the control signal CON_S with the temperature behaviour within the sixth predefined range.

In a further step M1/11, the control signal CON_S is applied to the voltage controlled attenuator VCA of the signal path SP.

If the RF input signal PF_IN is for example above the activation threshold of the AGC and if the ambient temperature for example decrease, influences of the decrease of the ambient temperature on the first power amplifier PA1, the power detector PD, and the voltage control circuit VCC of the feedback path FPT are compensated by the temperature behaviour of the voltage divider circuit VDC.

For example, the gain characteristic of the first power amplifier PA1 decreases with increasing operating temperature.

In a first alternative, the device DEV1 may be operated to keep the RF output signal RF_OUT within a seventh predefined range. This provides the advantage of providing a power level of RF output signal RF_OUT, which is independent of the ambient temperature level.

In a second alternative, the device DEV1 may be operated to increase a power level of the RF output signal RF_OUT with increasing ambient temperature. This provides the benefit of compensating a decrease of the power level of the RF output signal RF_OUT during further processing for example by temperature dependent components of the receiver.

By the first method M1 according to the first, second, and third embodiment of the invention, disturbing signals being generated at the power detector PD and travelling in the backward direction BD towards the signal path SP are blocked or attenuated by the first power amplifier PA1.

This provides a benefit of increasing signal quality of the RF output signal RF OUT. The first power amplifier PA1 is used on the one hand to enhance the sensitivity of the feedback path FP1. On the other hand, an isolating characteristic of the first power amplifier PA1 in the backward direction BD opposite to an amplification direction is used to suppress any disturbing signals travelling back to the signal path SP.

Referring to Figure 3, a block diagram of the voltage divider circuit VDC is shown in accordance to a third application of the third embodiment of the invention.

The voltage divider circuit VDC comprises between a positive electrical potential + 12 V and ground potential GND a first voltage divider, which is represented by a first resistor R1 and by a serial connection of three diodes D1, D2, D3.

A voltage at the serial connection of the three diodes D1, D2, D3 depends on the ambient temperature. Therefore, the temperature behaviour of the control signal CON_S may be adjusted by at least one diode D1, D2, D3 of the voltage divider circuit VDC according to a first application of the third embodiment of the invention.

The voltage at the serial connection of the three diodes D1, D2, D3 is provided to a second voltage divider, which is given by a second resistor R2 and a transistor T1.

A third resistor R3 and a fourth resistor R4 are used to adjust an operating point of the transistor T1.

The operating point of the transistor T1 determines a temperature behaviour of the transistor T1 according to the ambient temperature. Therefore, the temperature behaviour of the control signal CON_S may be adjusted by at least one transistor T1 of the voltage divider circuit VDC according to a second application of the third embodiment of the invention. According to the third application of the third embodiment of the invention as shown in Figure 3, the temperature behaviour of the control signal CON_S may be adjusted by a combination of at least one diode and at least one transistor of the voltage divider circuit VDC.

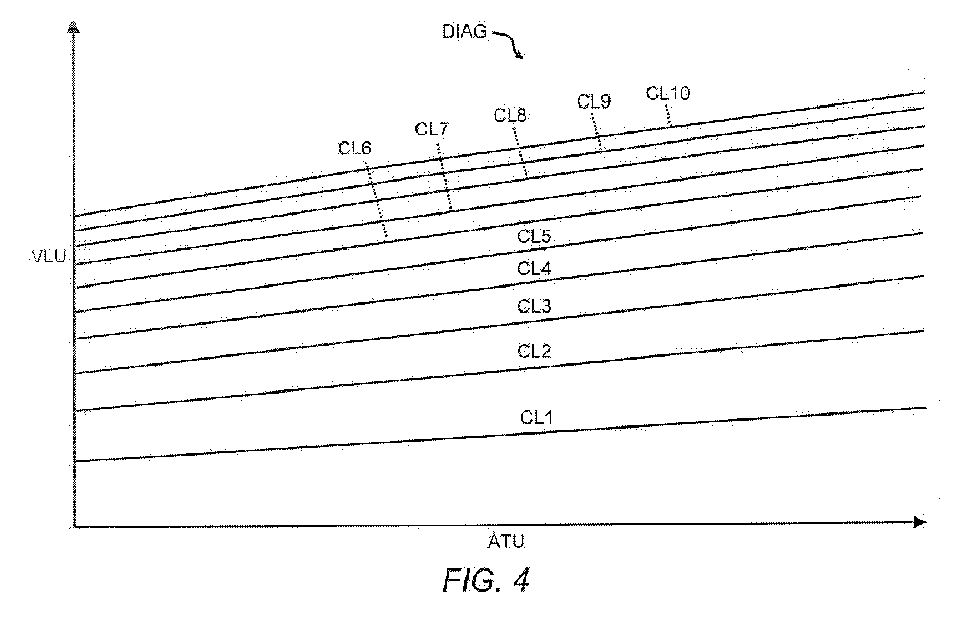

According to a fourth application of the third embodiment of the invention, an operating point of the voyage divider circuit VDC may be adjusted by choosing an adequate resistance value of the fourth resistor R4 (see Figure 4).

In on alternative, an operating point of the voltage divider circuit VDC may be adjusted by choosing an adequate resistance value of the third resistor R3.

Capacitors C1, C2 are used for eliminating any AC parts of the reference signal REF_S1. This provides the advantage of providing a DC signal for the reference signal REF_S1 with a higher quality.

Alternatively, a voltage divider circuit with other combinations of temperature depended electrical components may be used, which provide a similar temperature behaviour for the reference signal REF_S1.

Referring to Figure 4 and in accordance to the fourth application of the third embodiment of the invention, a characteristic diagram DIAG shows ten characteristic lines CL1, CL2, CL3, CL4, CL5, CL6, CL7, CL8, CL9, CL10 of the voltage of the reference signal REF_S1 of arbitrary voltage level units VLU for different resistance values of the fourth resistor R4 as a function of the ambient temperature with arbitrary ambient temperature units ATU.

By varying the resistance value for example from 100 Ohm (for first characteristic line CL1) in 100 Ohm steps to 1000 Ohm (for tenth characteristic line CL10) different gradients and different mean levels of the voltage of the reference signal REF_S1 can be obtained.

The use of the serial connection of the three diodes D1, D2, D3 provides the advantage of providing large gradients of the ten characteristic lines CL1, CL2, CL3, CL4, CL5, CL6, CL7, CL8, CL9, CL10.

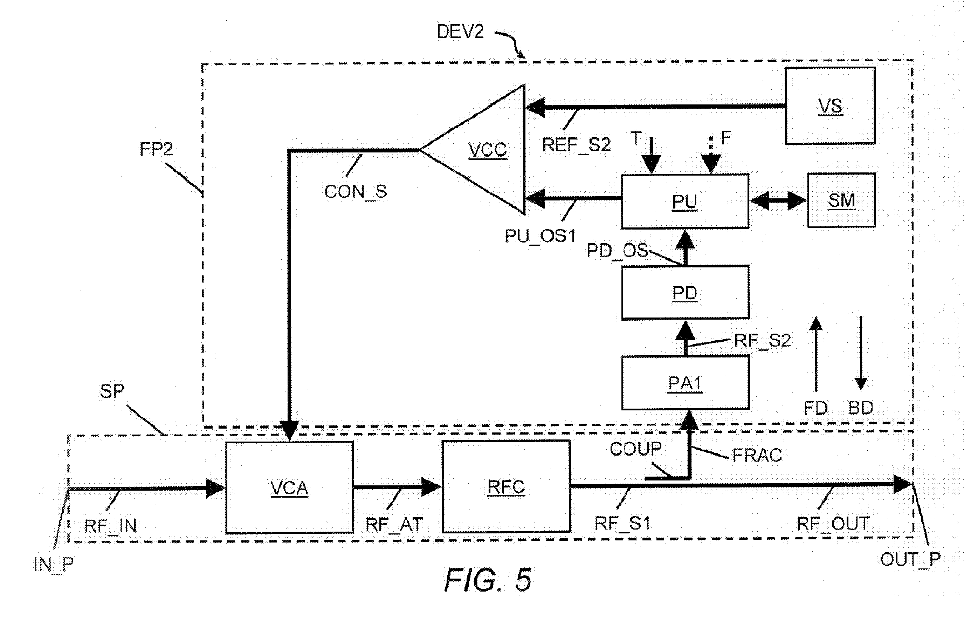

Referring to Figure 5 a block diagram of a device DEV2 comprising the RF circuit RFC in accordance to a first application of a fourth and a fifth embodiment of the invention is shown. The elements in the embodiment shown in figure 5 that correspond to elements of the embodiment of Figure 1 have been designated by the same reference numerals. In comparison to Figure 1, the device DEV2 does not comprise the voltage divider circuit VDC. Instead of this, the voltage of the voltage supply VS is directly applied as a reference signal REF_S2 to the second input of the voltage control circuit VCC. A voltage offset required for generating an adequate difference signal is generated by the reference signal REF_S2. Furthermore in comparison to Figure 1, the device DEV2 comprises between the power detector PD and the first input of the voltage control circuit VCC a processing unit PU, a storage medium SM, and first measuring equipment for measuring the ambient temperature. The first measuring equipment is not explicitly shown in Figure 5. Any measuring equipment known in the art may be used for the first measuring equipment, which provides an analogue or digitised first, measurement signal T of the ambient temperature. The first measurement signal T of the ambient temperature is applied to the processing unit PU.

In an alternative, the device DEV2 may further comprise second measuring equipment for measuring a frequency of the fraction FRAC of the first RF signal RF_S1 or alternatively the frequency of the RF input signal RF_IN, the first RF signal RF_S1 or the RF output signal RF_OUT. The second measuring equipment is not explicitly shown in Figure 5. Any measuring equipment known in the art may be used for the second measuring equipment, which provides an analogue or digitised second measurement signal F of the frequency. The second measurement signal F of the frequency of the first RF signal RF_S1 may be applied to the processing unit PU in addition.

The processing unit PU is connected to the storage medium SM. In an alternative, the processing unit PU may comprise an internal digital data storage medium and the additional storage medium SM is not required. The processing unit PU is for example a microcontroller designed for small applications. In an alternative, the processing unit may be a microprocessor. Moreover, explicit use of the term microprocessor or microcontroller should not be construed to refer exclusively to hardware capable of executing software, and may implicitly include, without limitation, digital signal processor (DSP) hardware, network processor, application specific integrated circuit (ASIC), field programmable gate array (FPGA) etc.

In a first alternative, the processing unit PU may comprise internal ADCs (ADC = analog-to-digital converter) at its input ports for the output signal PD_OS of the power detector PD, for the analogue first measurement signal T of the ambient temperature, and for the analogue second measurement signal F of the frequency and a DAC (DAC = digital-to-analog converter) at its output port for an output signal PU_OS1 of the processing unit PU.

In a second alternative, the device DEV2 may comprise external ADCs at the inputs of the processing unit PU and a separate DAC at the output of the processing unit PU.

In a third alternative, internal or external ADCs for the first measurement signal T of the ambient temperature and for the second measurement signal F of the frequency are not required, if the first and the second measurement equipment directly provide digitised values for the first measurement signal T and for the second measurement signal F. The storage medium SM is for example an EEPROM (EEPROM = electrically erasable programmable read-only memory). In an alternative, the storage medium SM may be magnetic storage media such as magnetic disks or magnetic tapes, hard drives, or optically readable digital data storage media.

The storage medium SM may be used for storing calibration data in a look-up table or in a database. The calibration data comprise a relation between a power level of the output signal PU_OSI of the processing unit PU, a power level of the output signal PD_OS of the power detector PD, and a value of the first measurement signal T of the ambient temperature.

In an alternative, the calibration data may comprise a relation between the power level of the output signal PU_OS1 of the processing unit PU, the power level of the output signal PD_OS of the power detector PD, the value of the first measurement signal T of the ambient temperature, and a value of the second measurement signal F of the frequency of the first RF signal RF_S1.

A set of values covering combinations of the power level of the output signal PU_OS1 of the processing unit PU, of the power level of the output signal PD_OS of the power detector PD, and of the first measurement signal T of the ambient temperature may be stored with a predefined spacing for a predefined temperature range.

Data of a raw of the look-up table, best fitting to the power level of the output signal PO_OS of the power detector PD and to the first measurement signal T of the ambient temperature, may be used to provide the power level of the output signal PU_OS1 of the processing unit PU. In an alternative, an interpolation for intermediate values not given in the tabular may be performed.

In a further alternative, the calibration data may be given as equation. This provides the advantage, that a power level of the input signal can be directly calculated and an interpolation for intermediate values is not required. The equation may be derived by fitting the equation to empirical values, which have been measured during a calibration process after the fabrication and prior to the delivery of the device DEV2 comprising the RF circuit, Similarly, the calibration data of the look-up table may have been obtained via empirical values during the calibration process.

In an alternative, the calibration data, may have been obtained via simulations using SPICE models or similar models describing electronic circuits.

In accordance to the fi rst application of the fourth embodiment of the invention by using temperature-dependent calibration data, the temperature behaviour of the control signal CON_S can be kept within an eight predefined range.

The device DEV3 according to the first application of the fourth and the fifth embodiment of the invention provides the advantage of using identical components for the feedback path FP2, because the temperature compensation effect is provided by the calibration data and the reference signal REF_S2 is not needed to be temperature dependent. Fabrication tolerances can be adapted by individual calibration data, which can be derived in the calibration process after the fabrication and prior to the delivery of the device DEV2 comprising the RF circuit. Depended on the performance requirements of the RF circuit RFC, some calibration data may be used for more than one device DEV2 comprising the RF circuit RFC. In accordance to the first application of the fifth embodiment of the invention by using frequency dependent calibration data, a frequency behaviour of the control signal CON_S can be kept within a ninth predefined range.

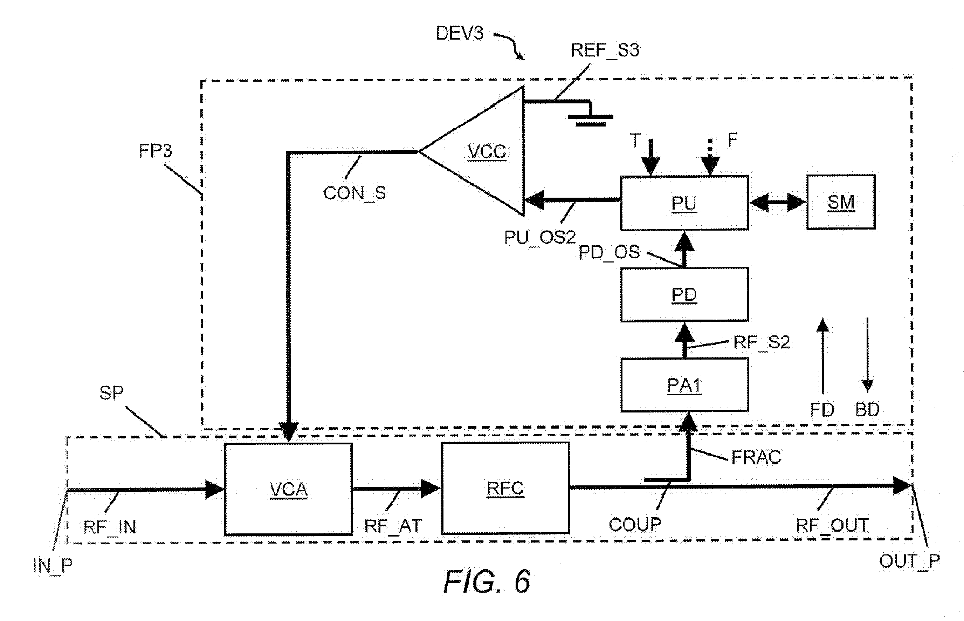

Referring to Figure 6 a block diagram of a device DEV3 comprising the RF circuit RFC in accordance to a second application of the fourth and the fifth embodiment of the invention is shown. The elements in the embodiment shown in Figure 6 that correspond to elements of the embodiment of Figure 5 have been designated by the same reference numerals.

In comparison to Figure 5, the device DEV3 does not comprise the voltage supply VS in a feedback path FP3.

According to the second application of the fourth and the fifth embodiment of the invention, a reference signal REF_S3 is generated by grounding the second input of the voltage control circuit VCC.

The voltage offset required for generating an adequate difference signal is generated by an output signal PU_OS2 of the processing unit PU and by adapting the calibration data accordingly.

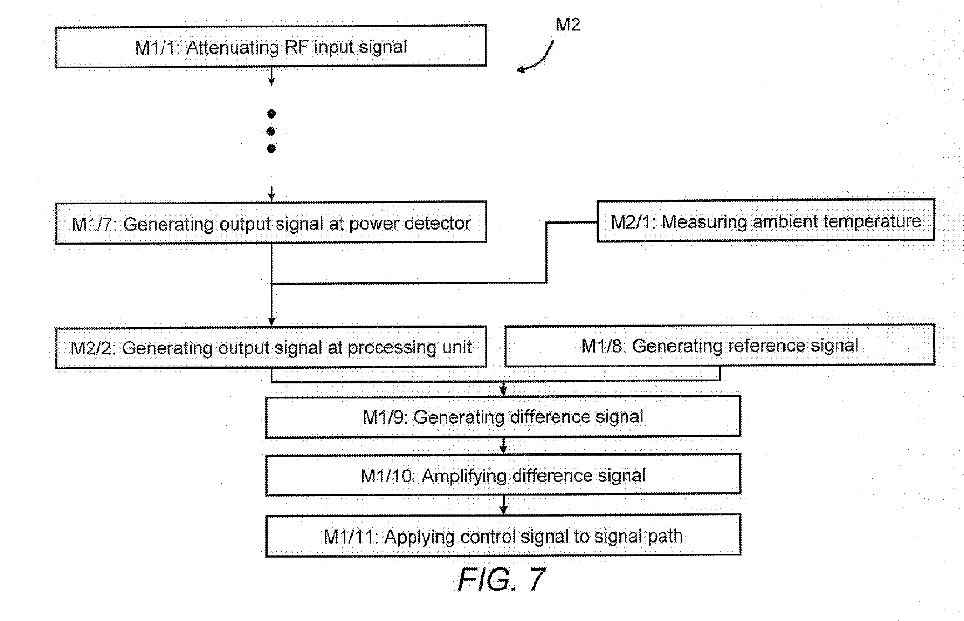

Referring to Figure 7 a flow diagram of a second method M2 in accordance to the fourth embodiment of the invention is shown. The elements shown in Figure 7 that correspond to elements of the Figure 2 have been designated by the same reference numerals. In addition to the steps M1/1, M1/2, M1/3, M1/4, M1/5, M1/6, M1/7, M1/8, M1/9, M1/10 and M1/11 of the first method M1, step M2/1 is performed in parallel to the steps M1/1 to M1/7 and step M2/2 is performed between the step M1/7 and the step M1/9.

The sequence and the number of the steps for performing the method M2 is not critical, and as can be understood by those skilled in the art, that the sequence and the number of the steps may vary without departing from the scope of the invention.

In the step M1/8, the reference signal REF_S2, REF_S3 is generated by the voyage supply VS or by grounding,

In the further step M2/1, the ambient temperature is measured using the first measuring equipment and the first measurement signal T of the ambient temperature is provided to the processing unit PU.

In the even further step M2/2, the processing unit PU generates the output signal PU_OS1, PU_OS2 according to the second RF signal RF_S2, the ambient temperature, and the calibration data being used at the processing unit PU.

The first measurement signal T of the ambient temperature and the output signal PD_OS of the power detector PD being provided to the processing unit PU are used at the processing unit PU to determine the power level of the output signal PU_OS1 of the processing unit PU. Therefore, the processing unit PU may use the look-up table, the database or the equation comprising the relation between the power level of the output signal PU_OS1 of the processing unit PU, the power level of the output signal PD_OS of the power detector PD, and the first measurement signal T of the ambient temperature.

In the step M1/9, the difference signal is generated by the voltage control circuit VCC for the reference signal REF_S2, REF_S3 and for the output signal PU_OS1, PU_OS2 of the processing unit PU.

In the step M1/10 the difference signal is amplified to the control signal CON_S with the temperature behaviour within an eighth predefined range and wherein the temperature behaviour or the control signal CON_S is adjusted by the calibration data.

In an alternative, the device DEV2 may be operated to increase a power level of the RF output signal RF_OUT with increasing ambient temperature. This provides the benefit of compensating a decrease of the power level of the RF output signal RF_OUT during further processing for example by temperature dependent components of the receiver.

The second method M2 according to the present invention offers a benefit of using identical components for the feedback path FP2, because the temperature compensation effect is provided by the calibration data and the reference signal REF_S2, REF_S3 is not needed to be temperature dependent. Fabrication tolerances can be adapted by individual calibration data, which can be derived in the calibration process after the fabrication and prior to the delivery of the device DEV2, DEV3 comprising the RF circuit. Depended on the performance requirements of the RF circuit RFC, same calibration data may be used for more than one device DEV2, DEV3 comprising the RF circuit RFC.

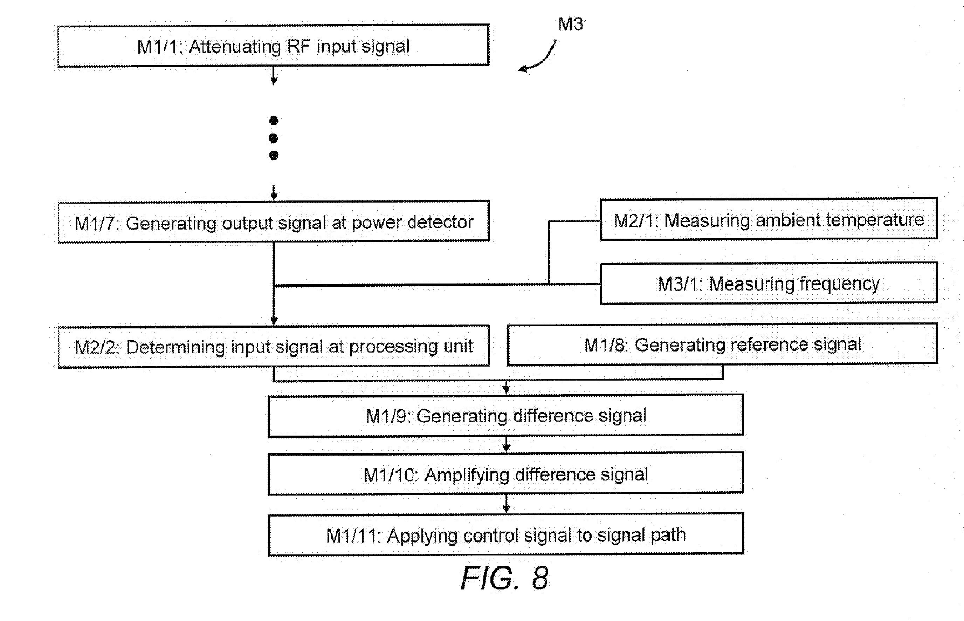

Referring to Figure 8 a flow diagram of a third method M3 in accordance to the fifth embodiment of the invention is shown. The elements shown in Figure 8 that correspond to elements of the Figure 7 have been designated by the same reference numerals. In addition to the steps M1/1 M1/2, M1/3, M1/4, M1/5, M1/6, M1/7, M1/8, M1/9, M1/10, M1/11, M2/1, and M2/2 of the second method M2, step M3/1 is performed in parallel to the steps M1/1 to M1/7 and the step M2/1.

The sequence and the number of the steps for performing the third method M3 is not critical, and as can be understood by those skilled in the art, that the sequence and the number of the steps may vary without depat-firig from the scope of the invention.

In the further step M3/1, the frequency of the first RF signal RF_S1 is measured using the second measuring equipment and the second measurement signal F of the frequency of the first RF signal RF_S1 is provided to the processing unit PU.

In an alternative, the frequency of the second RF signal RF_S2 may be measured by the power detector PD and the output signal PD_OS of the power detector PD comprises a first parameter for the power level of the second RF signa RF_S2 and a second parameter for the frequency of the second RF signal RF_S2.

In the step M2/2, the processing unit PU generates the output signal PU_OS1, PU_OS2 of the processing unit PU according to the power level of the second RF signal RF_S2, the ambient temperature, the frequency of the first RF signal RF_S1, and the calibration data being used at the processing unitPU.

The first measurement signal T of the ambient temperature, the output signal PD_OS of the power detector PD, and the second measurement signal F of the frequency of the first RF signal RF_S1 are used at the processing unit PU to determine the power level of the output signal PU_OS1, PU_OS2 of the processing unit PU. Therefore, the relation of the calibration data further incorporates the second measurement signal F of the frequency of the first RF signal RF_S1.

In the step M1/10, the difference signal is amplified to the control signal CON_S with the frequency behaviour within the ninth predefined range and wherein the frequency behaviour of the control signal CON_S is adjusted by the calibration data.

In an alternalive, the device DEV3 may be operated to increase a power level of the RF output signal RF_OUT with increasing frequency. This provides the benefit of compensating a decrease of the power level of the RF output signal RF_OUT during further processing for example by frequency dependent components of the receiver, which usually attenuate RF signals with an increasing level, if the frequency of the RF signals increases.

The third method M3 according to the present invention provides the benefit of keeping the power level of the RF output signal RF_OUT of the device DEV2, DEV3 within the ninth predefined range for b predefined frequency range. Therewith, the third method M3 allows using the device DEV2, DEV3 in a larger frequency range without signal degradation of the RF output signal RF_OUT.

In a further embodiment of the invention, the feedback path may not comprise all components of the AGC and may only comprise the first power amplifier PA1 and the power detector PD just for power monitoring purposes of the RF output signal RF_OUT of the RF circuit.

This provides the advantage, of observing any degradation of components of the RF circuit RFC or to measure a power efficiency of the RF circuit RFC.

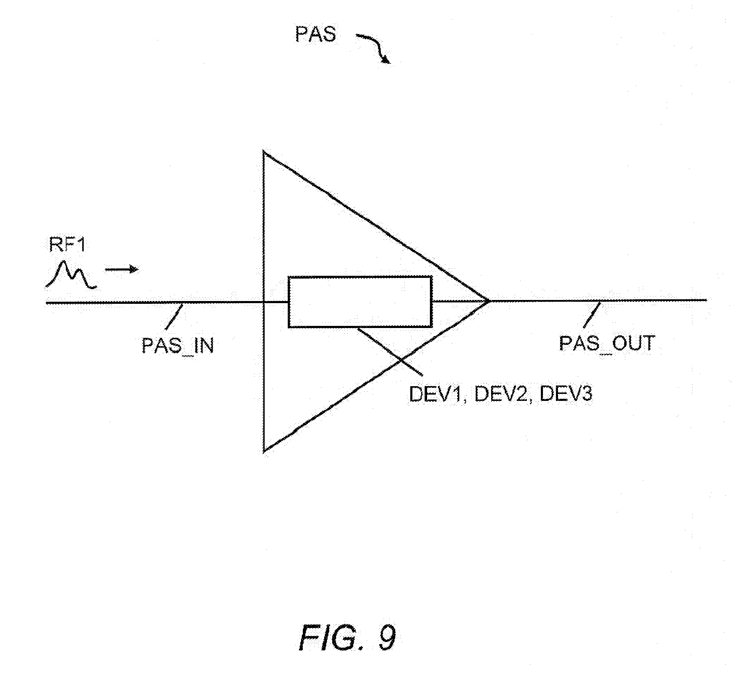

Figure 9 shows a block diagram of a power amplifier system PAS according to the embodiments and the applications of the embodiments of the invention.

The power amplifier system PAS comprises at least one input path PAS_IN at least one device DEV1, DEV2, DEV3 and at least one output path FAS_OUT,

The power amplifier system PAS may be contained in a transmitter of a network element of a radio communication system such as an LTE system, a WiMAX system, or a WLAN system.

In an alternative, the power amplifier system PAS may be contained in an audio of video system such as a hi-fi system or an AM radio.

The power amplifier system PAS may be a unidirectional or a bi-directional power amplifier system.

The RF circuit RFC of the at least one device DEV1, DEV2, DEV3 comprise at least one second power amplifier.

A power amplifier system input RF signal RF1 being received via the at least one input path PAS_IN is provided to the input port IN_P of the at least one device DEV1, DEV2, DEV3 comprising the RF circuit RFC.

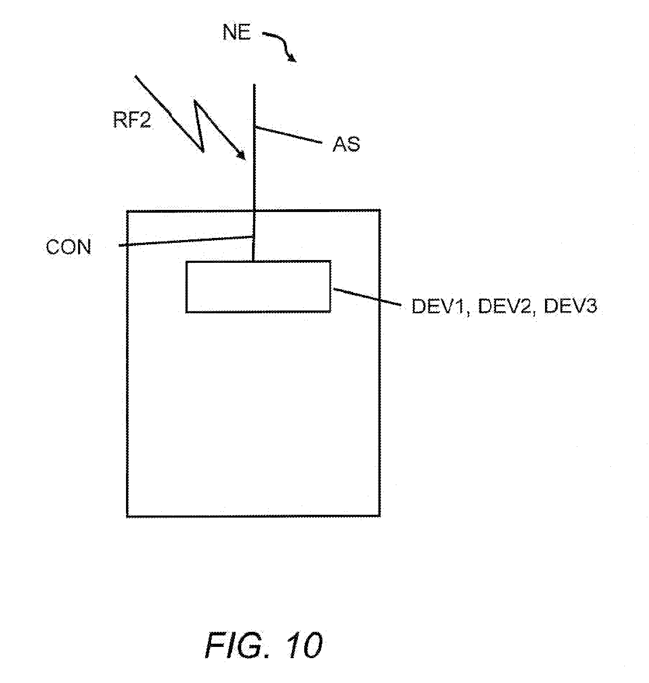

Figure 10 shows a block diagram of a network element NE according to the embodiments and the application of the embodiments of the invention. The network element NE comprises at least one antenna system AS, at least one connection CON, and at least one device DEV1, DEV2, DEV3.

Further components and interfaces usually used in the network element NE are not shown.

The network element NE may be for example a base station. Further alternatives for the network element are a repeater, a mobile phone, a PDA, a notebook, a USB flash drive etc.

A network element input RF signal RF2 being received via the at least one antenna system AS is transmitted via the at least one connection CON to the input port IN_P of the at least one device DEV1, DEV2, DEV3 comprising the RF circuit RFC.

## Claims

1. A method for preventing impacts of a power detector (PD) on signal path (SP) of an RF circuit (RFC), said method comprising the steps of:
- coupling a fraction (FRAC) of a first RF signal (RF_S1) from said signal path (SP) to a feedback path (FP1, FP2, FP3),
**characterized in that** the method further comprises the steps of:
- amplifying said fraction (FRAC) of said first RF signal (RF_S1) to a second RF signal (RF_S2) via a first power amplifier (PA1) of said feedback path (FP1, FP2, FP3),
- detecting said amplified second RF signal (RF_S2) at said power detector (PD) of said feedback path (FP1, FP2, FP3), and
- attenuating disturbing signals at said first power amplifier (PA1) in a backward direction (BD) of said first power amplifier (PA1),

2. The method according to claim 1, wherein said fraction (FRAC) of said first RF signal (RF_S1) is below a first predefined threshold.

3. The method according to claim 1, wherein a power level of said second RF signal (RF_S2) is adapted to an operating point of said power detector (PD) with a sensitivity above a second predefined threshold.

4. The method according to claim 3, wherein said operating point of sold power detector (PD) is adjusted by said fraction (FRAC) of said first RF signal (RF_S1) being within a first predefined range.

5. The method according to claim 3, wherein said operating point of suid power detector (PD) is adjusted by an operating gain of said first power amplifier (PA1) being within a second predefined range.

6. The method according to claim 1, said method further comprises the steps of:
- generating an output signal (PD_OS) atsaid power detector (PD) for said second RF signed (RF_S2),
- generating a reference signal (REF_S1) by a voltage divider circuit (VDC).
- venerating a difference signal fo said reference signal (REF_S1) and for said output signal (PD_OS) of said power defector (PD),
- amplifying said difference signal to a control signal (CON_S) with a temperature behaviour within a sixth predefined range, and
- applying said control signal (CON_S) to said signal path (SP).

7. The method according to claim 6, wherein said temperature behaviour is adjusted by at least one diode (D1, D2, D3) of said voltage divider circuit (VDC),

8. The method according to claim 6, wherein said temperature behaviour is adjusted by at least one transistor (T1) of said voltage divider circuit (VDC).

9. The method according to claim 6, wherein an operating point of said voltage divider circuit (VDC) is adjusted by at least one resistor (R3, R4) of said voltage divider circuit (VDC).

10. The method according to claim 1, said method further comprises the steps of:
- generating a reference signal (REF_S2, REF_S3),
- measuring an ambient temperature,
- generating an output signal (PU_OS1, PU_OS2) at a processing unit (PU) for said second RF signal (RF_S2), for said ambient temperature and for calibration data of said processing unit (PU),
- generating a difference signal for said reference signal (REF_S2, REF_S3) and for said output signal (PU_OS1, PU_OS2) of said processing unit (PU),
- amplifying said difference signal to a control signal (CON_S) with a temperature behaviour within on eighth predefined range, and
- applying said control signal (CON_S) to said signal path (SP) and wherein said temperature behaviour is adjusted by said calibration data.

11. The method according to claim 10, wherein said reference signal (REF_S3) is generated by grounding.

12. The method according to claim 10, said method further comprises the step of measuring a frequency of an RF signal (FRAC, RF_S1, RF_IN, RF_OUT), and wherein said amplifying of said difference signal to said control signal (CON_S) is done with a frequency behaviour within a ninth predefined range,
and wherein said frequency behaviour is adjusted by said calibration data,

13. A device (DEV1, DEV2, DEV3) comprising an RF circuit (RFC) in a signal path (SP), said device further comprises:
- means for coupling a fraction (FRAC) of a first RF signal (RF_S1) from said signal path (SP) to a feedback path (FP1, FP2, FP3),
**characterized in that** said device (DEV1, DEV2, DEV3) further com prises:
- means for amplifying said fraction (FRAC) of said first RF signal (RF_S1) to a second RF signal (RF_S2) via a first power amplifier (PA1) of said feedback path (FP1, FP2, FP3),
- means for detecting said amplified second RF signal (RF_S2) at said power detector (PD) of said feedback path (FP1, FP2, FP3), and
- means for attenuating disturbing signals at said first power amplifier (PA1) in a backward direction (BD) of said first power amplifier (PA1).

14. A power amplifier system (PAS) comprising at least one device (DEV1, DEV2, DEV3) according to claim 13.

15. A network element (NE) comprising at least one device (DEV1, DEV2, DEV3) according to claim 13.

## Amended claims

### Amended claims in accordance with Rule 137(2) EPC.

**1.** A method for preventing impacts of a power detector (PD) on a signal path (SP) of an RF circuit (RFC), said method comprising the steps of:
- coupling a fraction (FRAC) of a first RF signal (RF_S1) from said signal path (SP) to a feedback path (FP1, FP2, FP3),
- amplifying said fraction (FRAC) of said first RF signal (RF_S1) to a second RF signal (RF_S2) via a first power amplifier (PA1) of said feedback path (FP1, FP2, FP3),
- detecting said amplified second RF signal (RF_S2) at said power detector (PD) of said feedback path (FP1, FP2, FP3), - attenuating disturbing signals at said first power amplifier (PA1) in a backward direction (BD) of said first power amplifier (PA1),
- generating a reference signal (ref_S1, REF_S2, REF_S3),
- generating a difference signal for said reference signal (REF_S1, REF_S2, REF_S3) and for an output signal (PD_OS) of said power detector (PD),
- amplifying said difference signal to a control signal (CON_S), and
- applying said control signal (CON_S) to said signal path (SP),
**characterized in that** said reference signal (REF_S1) or calibration data of said feedback path (FP2, FP3) provide a temperature compensation property for a temperature characteristic of active components (PAl, PD) of said feedback path (FP1, FP2, FP3) on said control signal (CON_S).

**2.** The method according to claim 1, wherein said reference signal (REF_S1) or said calibration data provide a temperature compensation property for a temperature characteristic of active components (VCA, RFC) of said signal path (SP) on said control signal (CON_S).

**3.** The method according to claim 1 or claim 2, wherein said reference signal (REF_S1) is generated by a voltage divider circuit (VDC) and wherein a temperature behaviour of said control signal (CON_S) is adjusted by at least one diode (D1, D2, D3) of said voltage divider circuit (VDC).

**4.** The method according to claim 1 or claim 2, wherein said reference signal (REF_S1) is generated by a voltage divider circuit (VDC) and wherein a temperature behaviour of said control signal (CON_S) is adjusted by at least one transistor (T1) of said voltage divider circuit (VDC).

**5.** The method according to claim 1 or claim 2, wherein said reference signal (REF_S1) is generated by a voltage divider circuit (VDC) and wherein an operating point of said voltage divider circuit (VDC) is adjusted by at least one resistor (R3, R4) of said voltage divider circuit (VDC).

**6.** The method according to claim 1, said method further comprises the steps of:
- measuring an ambient temperature, and
- generating an output signal (PU_OS1, PU_OS2) at a processing unit (PU) for said second RF signal (RF_S2), for said ambient temperature and for calibration data of said processing unit (PU), and wherein said reference signal (REF_S3) is generated by grounding.

**7.** The method according to claim 6, said method further comprises the step of measuring a frequency of an RF signal (FRAC, RF_S1, RF_IN, RF_OUT), and wherein said amplifying of said difference signal to said control signal (CON_S) is done with a frequency behaviour within a predefined range,
and wherein said frequency behaviour is adjusted by said calibration data.

**8.** A device (DEV1, DEV2, DEV3) comprising an RF circuit (RFC) in a signal path (SP), said device further comprises:
- means for coupling a fraction (FRAC) of a first RF signal (RF_S1) from said signal path (SP) to a feedback path (FP1, FP2, FP3),
- means for amplifying said fraction (FRAC) of said first RF signal (RF_S1) to a second RF signal (RF_S2) via a first power amplifier (PA1) of said feedback path (FP1, FP2, FP3),
- means for detecting said amplified second RF signal (RF_S2) at said power detector (PD) of said feedback path (FP1, FP2, FP3), - means for attenuating disturbing signals at said first power amplifier (PA1) in a backward direction (BD) of said first power amplifier (PA1),
- means for generating a reference signal (REF_S1, REF_S2, REF_S3),
- means for generating a difference signal for said reference signal (REF_S1, REF_S2, REF_S3) and for an output signal (PD_OS) of said power detector (PD),
- means for amplifying said difference signal to a control signal (CON_S), and
- means for applying said control signal (CON_S) to said signal path (SP),
**characterized in that** said reference signal (REF_S1) or calibration data of said feedback path (FP2, FP3) provide a temperature compensation property for a temperature characteristic of active components (PA1, PD) of said feedback path (FP1, FP2, FP3) on said control signal (CON_S).

**9.** A power amplifier system (PAS) comprising at least one device (DEV1, DEV2, DEV3) according to claim 8.

**10.** A network element (NE) comprising at least one device (DEV1, DEV2, DEV3) according to claim 8.
